(19) Europäisches Patentamt
European Patent Office
Office européen des brevets

(11) **EP 4 607 144 A2**

(12) **EUROPEAN PATENT APPLICATION**

(43) Date of publication:
**27.08.2025  Bulletin 2025/35**

(21) Application number: **25188063.9**

(22) Date of filing: **08.07.2025**

(51) International Patent Classification (IPC):
**G01B 9/02004** *(2022.01)*    **G01B 9/02001** *(2022.01)*
**G01B 9/02055** *(2022.01)*    **G03F 7/00** *(2006.01)*

(52) Cooperative Patent Classification (CPC):
**G01B 9/02007; G01B 9/02004; G01B 9/02072;**
**G03F 7/70775;** G01B 2290/60

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(71) Applicant: **ASML Netherlands B.V.**
**5500 AH Veldhoven (NL)**

(72) Inventor: **JANSEN, Maarten Jozef**
**Veldhoven (NL)**

(74) Representative: **ASML Netherlands B.V.**
**Corporate Intellectual Property**
**P.O. Box 324**
**5500 AH Veldhoven (NL)**

(54) **METHOD OF CALIBRATING A TUNABLE LIGHT SOURCE IN AN INTERFEROMETER SYSTEM**

(57)    The present disclosure provides method of calibrating a tunable light source in an interferometer system, the method comprising the steps of: - simultaneously performing a frequency sweep with the tunable light source across at least one measurement axis and a reference axis of the interferometer system to obtain a frequency response; - obtaining a fit residual of the frequency response of the tunable light source; - obtaining a noise fingerprint of the fit residual; - correlating the noise fingerprint to a reference noise fingerprint; and - calibrating the tunable light source based on the correlation between the noise fingerprint and the reference noise fingerprint.

Fig. 2

EP 4 607 144 A2

**Description**

FIELD

The present invention relates to a method of calibrating a tunable light source in an interferometer system and to an interferometer system adapted for said method. The interferometer system may be applied in, for instance, an exposure apparatus in general, or for instance in a projection system or an object stage of a lithographic apparatus.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

Interferometers are used for various measurements in the lithographic apparatus and in other equipment related to the semiconductor fabrication process, including metrology. For instance, wavelength trackers may be used to control stability of laser beam inputs, while the position of movable equipment such as object stages and optical elements may be controlled up to nm level using one or more phase tracking interferometers.

Interferometers may use multiple inputs. One example is a tunable laser. Herein, the light frequency or wavelength fed to the interferometer may be modulated, to obtain certain results. Said results may include, but are not limited to, measuring the length of an optical path.

Known methods of absolute distance metrology may be based on tuning or modulating the wavelength of the light input into the interferometer system while measuring the corresponding change of phase. The amount of phase change scales directly with the optical path length difference (OPD) of the interferometer. OPD herein refers to the difference between a measurement path with respect to a reference having a fixed length.

To obtain accurate measurements, the wavelength of the modulated light input should be known. At the start of operation, typically, the setup can be calibrated. During operation however, the wavelength may drift. Methods are available to measure the wavelength of a tunable laser, for instance using one or more of a spectral absorption gas reference cell, a grating-based spectrometer, and by comparison versus a reference laser having a fixed (known) frequency.

Interferometer systems herein may typically measure period count, i.e. the number of times a laser wavelength fits into the optical path length. The period counts however are inherently afflicted by integer period count errors. A calibration process to determine these errors so as to determine an absolute distance may be referred to as 'zeroing'.

A multi-wavelength interferometer may be zeroed (calibrated) by minimizing the fit residual of goal functions. WO 2024/002595 A1 describes a zeroing method for a multiwavelength interferometer using a tunable laser. Herein, a count offset is determined using a non-linear equation.

Despite the relatively high accuracy of state of the art interferometers, due to the ongoing improvements to lithographic systems and the corresponding decreasing feature sizes of products, processes may run into the limits of the positioning systems. A problem relates for instance to imperfections of interferometer measurements due to so-called ghost rays. The interferometer optics surfaces may have slightly imperfect antireflection coatings and/or improper wedging of optical components, resulting in unintentionally reflected light beams traveling through the interferometer optics. Part of these unintended internal reflections may be added to the output, thereby introducing measurement errors.

For instance, a four-pass interferometer system has many optical interfaces which makes it a challenge to avoid ghost reflections over a large tilt range of the mirror target. If one or more of these ghost ray reflections are provided to the receiver, it will result in a phase measurement error. When calibrating a tunable laser, the phase measurement error will cause a drift of the fit residual of the tunable laser. A drift of the fit residual as function of the phase of the wavelength tracker interferometer, which is typically included in the interferometer system, indicates that the frequency of the tunable laser is shifted.

Ghost reflections typically introduce measurement errors that are laser wavelength dependent. This typically results in tighter requirements on laser wavelength stability. Ghost rays that interact with the target mirror can additionally impact cyclic error and higher order tilt dependency errors.

US-20230168077-A1 discloses a system, wherein the cyclic error can be used to determine a corrective value that can be stored in the processing unit, for example as a formula or lookup table, to compensate for the cyclic error during operational measurements of the interferometer system. The calculation of the cyclic error is based on the effect that changing the frequency of a measurement beam between measuring a first measurement value and a further first measurement value will result in a phase shift between the first measurement value and the further first measurement value. During operational use of the interferometer system, the derived cyclic error parameters, i.e. the corrective values, can be used to reconstruct corrected measurement values of the interferometer system without cyclic errors.

US-20230168077-A1 however lacks a method to overcome ghost ray errors.

The imperfections result in errors which can also transfer into the fit residuals to be minimized during interferometer zeroing or other calibration techniques. The transfer of these errors during calibration accordingly can result in inaccurate calibration of the interferometer system.

Calibrating a tunable laser against a reference laser typically requires additional hardware, such as wavelength meters (which are typically positioned outside the interferometer system), or additional tracing of object moves (to use the object motion with the stable laser as a wavelength meter to determine the wavelength of the laser to be calibrated). However, it is desirable to accurately determine the wavelength of a tunable laser without relying on additional hardware or additional tracing of object moves. Additional hardware typically increases capital expenses and requires space. Additional tracing requires time and consequently reduces machine uptime and throughput.

Solving non-linear equations for calibration, as disclosed in for instance WO-2024/002595-A1, can be complex and time-consuming, and therefore may mostly be suitable for startup of operation but less so for re-calibration during operation.

The present disclosure aims to provide an improved method and system.

SUMMARY

The disclosure provides a method and system as described in the appended claims.

The disclosure provides a method of calibrating a tunable light source in an interferometer system, the method comprising the steps of:

- simultaneously performing a frequency sweep with the tunable light source across at least one measurement axis and a reference axis of the interferometer system to obtain a frequency response;
- obtaining a fit residual of the frequency response of the tunable light source;
- obtaining a noise fingerprint of the fit residual;
- correlating the noise fingerprint to a reference noise fingerprint; and
- calibrating the tunable light source based on the correlation between the noise fingerprint and the reference noise fingerprint.

In an embodiment, the step of obtaining a fit residual of the frequency response comprises obtaining a first fit for at least a first frequency range and a second fit for another, second frequency range.

In an embodiment, the step of obtaining a noise fingerprint comprises:

performing a Fourier transform (FFT) of the fit residual; and
equalizing the Fourier power spectrum.

In an embodiment, the step of simultaneously performing a frequency sweep with the tunable light source includes performing a frequency sweep across multiple measurement axes and the reference axis of the interferometer system to obtain a frequency response.

In an embodiment, the step of obtaining the fit residual includes averaging the fit residual relating to the multiple measurement axes.

In an embodiment, the step of calibrating the tunable light source comprises correcting a frequency of the tunable light source.

In an embodiment, the interferometer system has frequency dependent measurement errors.

According to another aspect, the disclosure provides an interferometer system comprising at least a tunable light source, the interferometer system further comprising:

a controller adapted for calibrating the tunable light source, by:

- simultaneously performing a frequency sweep with the tunable light source across at least one measurement axis and a reference axis of the interferometer system to obtain a frequency response;
- obtaining a fit residual of the frequency response of the tunable light source;
- obtaining a noise fingerprint of the fit residual;
- correlating the noise fingerprint to a reference noise fingerprint; and
- calibrating the tunable light source based on the correlation between the noise fingerprint and the reference noise fingerprint.

In an embodiment, the controller is further adapted to obtain a first fit for at least a first frequency range and a second fit for another, second frequency range.

In an embodiment, the interferometer system comprises a first light source for providing a stabilized first light output.

In an embodiment, the interferometer system comprises multiple measurement axes, and the controller is adapted to perform a frequency sweep across the multiple measurement axes and the reference axis of the interferometer system to obtain a frequency response, and to obtain the fit residual including averaging the fit residual relating to the multiple measurement axes.

According to another aspect, the disclosure provides an exposure apparatus, comprising at least one interferometer system as described above.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic representation of an exemplary heterodyne interferometer system;
- Figure 3 depicts an exemplary diagram of fringe count of an interferometer i ($\Delta$cnt,i) versus fringe count of a wavelength tracker WLT ($\Delta$cnt,WLT), including an example of noise;
- Figure 4 depicts an exemplary diagram of error (Err.) versus change in fringe count ($\Delta$cnt);
- Figure 5 depicts an exemplary diagram of a difference in phase count ($\Delta$cnt.) error frequency (horizontal axis) between a variable axis and a stable axis (wavelength tracker) of an interferometer; and
- Figure 6 depicts a detail of the diagram of Figure 5, including a noise cancellation fit in accordance with an embodiment of the present disclosure.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultraviolet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created on a target portion of the substrate. The patterning device may be transmissive or reflective, binary, phase-shifting, hybrid, etc. Other examples of a patterning device include a programmable mirror array and a programmable LCD array.

A "beam splitter" or "beamsplitter" is an optical device that splits a beam of light in two.

"Refractive Index" (Index of Refraction) is a value calculated from the ratio of the speed of light in a vacuum to that in a second medium of greater density. The refractive index variable may be symbolized by the letter n or n' in descriptive text and mathematical equations.

An "interferometer" can measure distance or displacement by measuring the phase difference between two light beams, one sent to a first reflector or first surface at a fixed reference distance, and one sent to a second reflector or surface at another distance. When the two reflected signals are recombined in the interferometer, the resulting phase is related to the distance of the second surface from the interferometer. If the distance of the second surface changes, so does the phase of the combined signal. The measurement can be made over relatively long distances while maintaining accuracy. Interferometer light sources may be lasers, but not exclusively. The light source may include, for instance, LEDs, SLDs, etc. The method and system of the present disclosure are generally applicable, independent of the type of light source.

A "homodyne interferometer" measures phase by comparing the intensities of two sinusoidal signals (sine and cosine). A single frequency laser source is used in homodyne systems, having for instance frequency F1. The laser beam from the stationary reference path is returned with frequency F1, but the beam from the (moving) measurement path is returned with a Doppler shifted frequency. These beams are interfered together in the detector to give a frequency difference, also referred to as the beat frequency. The frequency difference is zero when the optics are stationary, while the frequency difference rises as the optics move in either direction.

A "heterodyne interferometer" uses a dual frequency laser source. The laser source may provide a single laser beam, which can be split in two wherein one of the two beams is given a frequency offset to allow for heterodyne phase detection. The two frequencies may also be generated by two different, frequency-locked or phase-locked lasers. In a heterodyne interferometer, the output beam from the dual frequency laser source may comprise two polarizations, one with a first frequency F1, the other with a different, second frequency F2. The frequency difference between them is F2 - F1. A polarizing beam-splitter reflects the light with first frequency F1 into the reference path. Light with the second frequency F2 passes through the splitter into the measurement path where it strikes a moving reflector causing the frequency of the reflected beam to be Doppler shifted by $\delta F$. This reflected beam is then combined with the F1 frequency light at the interferometer, and returned to the laser detector unit with a new frequency difference of F2 - F1 $\pm \delta F$. The beat frequency of a heterodyne laser system varies with the velocity of the moving reflector. When the optics are stationary, the beat frequency is F2 - F1. As the optics move apart, the beat frequency rises by $\delta F$, if they move together it falls.

A "wavelength tracker" is a specific version of an interferometer set up to measure a phase difference between two reflected light beams, one beam reflecting on a first fixed reflector providing a first reference axis and a second beam reflecting on a second fixed reflector providing a second reference axis having a different length than the first axis. As the two reflective surfaces are fixed, the measured phase difference will change only if the wavelength of the light beam changes. Thus, a wavelength tracker allows to monitor deviations of the wavelength from a setpoint.

"Polarization" of light refers to an intensity difference between respective polarization states of a laser beam. P-polarized light (from the German word parallel) has its electric field polarized parallel to the plane of incidence. S-polarized light (from the German word senkrecht) is perpendicular to the plane of incidence.

In the description below, reference may be made to either the wavelength of a light beam or its frequency. Generally speaking, in vacuum, wavelength and frequency are related according to:

$$f = \frac{c}{\lambda}$$

wherein $\lambda$ is wavelength, f is frequency, and c is the speed of light. However, the wavelength becomes shorter if the wave of light moves from a first medium having a first density to a second, denser medium. The frequency of the light however does not change when the wave moves from one medium to another. The speed of the wave v is related to both the frequency f and the wavelength $\lambda$:

$$v = \lambda f$$

Combining the above expression for velocity with the definition of index of refraction, the relationship between the wavelength $\lambda 0$ = c/f in vacuum and the wavelength $\lambda 1$ = v1/f in a first medium other than vacuum, wherein n1 is the refractive index of the first medium, is:

$$\frac{\lambda 0}{\lambda 1} = \frac{\frac{c}{f}}{\frac{v1}{f}} = \frac{fc}{fv1} = \frac{c}{v1} = n1$$

When setting tunable lasers to a selected setpoint, it is an option to determine the wavelength of the laser light while travelling through the first medium. An alternative is to tune the frequency of the laser light in the laser itself.

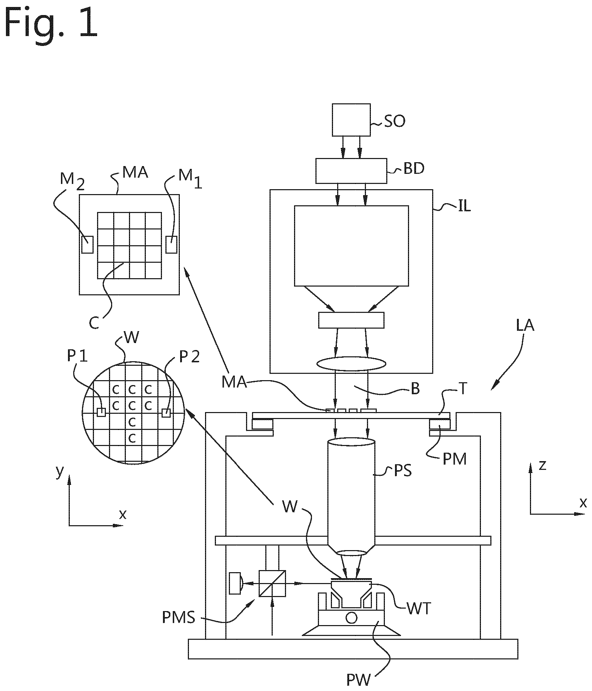

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

As depicted in Figure 1, the lithographic apparatus is of a transmissive type (e.g. employing a transmissive mask). Alternatively, the apparatus may be of a reflective type (for instance including reflective optical elements in the projection system and the illumination system, and/or including a reflective mask).

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system PMS, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

One or more interferometer systems may typically be used for accurate position measurements of elements of the lithographic apparatus LA. For instance, the position measurement system PMS, as exemplified in Fig. 1, may include one or more interferometer systems to measure the position of the substrate table WT. Alternatively, optical elements as included in the illumination system IL and/or the projection system PS may be movable in one or more degrees of freedom. Herein, said optical elements may be provided with one or more interferometer systems to control movement and measure the position of the respective optical element. Each movable optical element may for instance be provided with an interferometer system for each respective degree of freedom of movement. Said six degrees of freedom may include any combination of translations along up to three mutually perpendicular axes (x, y, z) as well as rotations around one or more of the aforementioned axes (Rx, Ry, Rz).

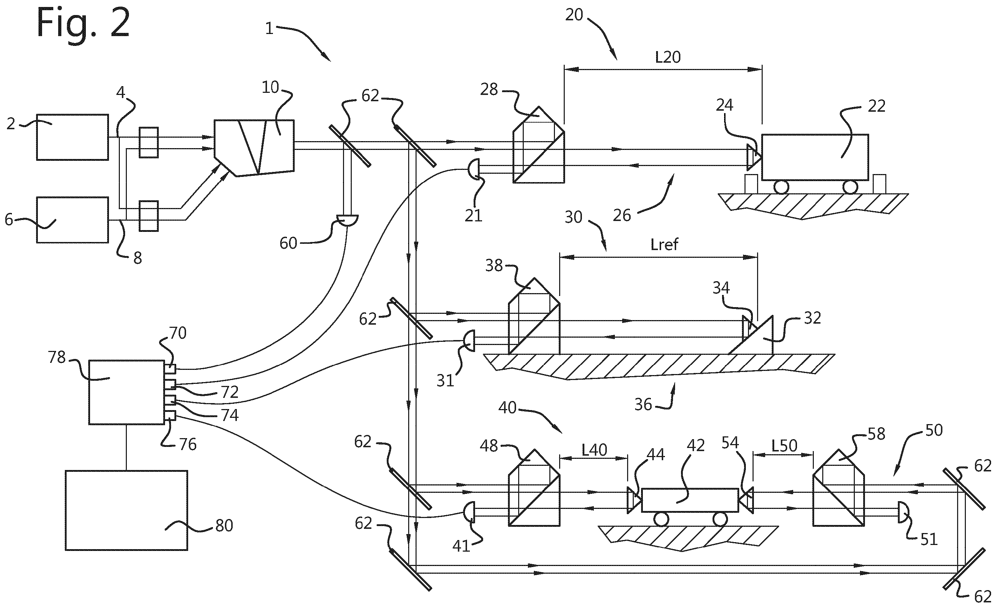

Figure 2 shows an exemplary overview of an interferometer system 1. For additional technical details, options and alternative embodiments, and methods to operate and use the interferometer system 1, reference is made to US20220048119.

The interferometer system 1 may comprise a first light source 2 to provide a first light beam 4 having a first frequency. The interferometer system 1 may comprise a second light source 6 for providing a second light beam 8 having a second frequency. Alternatively, the second light beam may be split from the first light beam and herein may be provided with an offset, such as a frequency offset or a phase offset.

The first light source 2 and/or the second light source 6 may be tunable lasers, able to provide a laser beam having a tunable or adjustable frequency.

**In** a practical embodiment, the first light source is provides a light beam having a fixed frequency, and the second light source is tunable. The first light source may include a stabilized laser. The second light source may include a tunable laser. The second light source may be a modulated wavelength laser (MWL).

Herein, adjusting the frequency of one or more of the laser sources may be referred to as frequency adjustment means for adjusting the first frequency and/or the second frequency. In practice, tunable lasers are available on the market. Examples of tunable lasers include laser diodes, lasers having an adjustable resonator cavity length, or the use of adjustable optical elements to adjust the laser output.

The first light source and/or the second light source may comprise, for instance, a stabilized HeNe laser.

In a practical embodiment, the first frequency and the second frequency may be in the order of gigahertz to terahertz. The frequency difference $\delta f = (f2 - f1)$ may be in the range of megahertz. For instance, $\delta f$ may be about 10 to 50 MHz.

The system 1 may comprise a recombiner 10 for combining the first light beam 4 and the second light beam 8. The combiner 10 is also known as a remote optical combiner (ROC). The first light beam and the second light beam may propagate along the same path(s) after being combined in the recombiner 10. The recombiner 10 may be, for instance, a Rochon prism. The combiner 10 may be designed or adapted to polarize the first laser beam 4 and/or the second laser beam 8. Herein, in a preferred embodiment, the combiner 10 may be adapted to provide an output wherein the first laser beam has a first polarization and wherein the second laser beam has another, second polarization. The first and second polarizations may typically be selected from s-polarization and p-polarization. So, the combiner 10 may combine as well as polarize the first laser beam 4 and the second laser beam 8.

One or both of the first and second beams of radiation may be guided towards one or more of a first interferometer 20, a second interferometer 30, a third interferometer 40, and a fourth interferometer 50. Alternative setups of an interferometer system are conceivable as well, including more or less interferometers than shown in Figure 2.

The first interferometer 20 may be set up to measure a location, movement or shape of a movable target 22 having a reflective surface 24. The first interferometer may be used to measure the length $L_{20}$, or a change thereof, of a first axis 26. In a practical embodiment, the interferometer 20 may be a fibre fed interferometer (FFI).

The second interferometer 30 may be a wavelength tracker, having a fixed target 32 provided with a second reflective surface 34. Herein, a second axis 36 may have a fixed length $L_{ref}$ which can be used as a reference. Said reference has a stable length with respect to a reference element 38 of the second interferometer 30. The second axis may, in a practical embodiment, include a highly stable cavity.

The third and/or fourth interferometers 40, 50 may measure displacement or position of a movable element 42. The movable element may be an object stage or an optical element. Herein, opposite sides of the element 42 may be provided with respective reflective surfaces 44, 54. The respective interferometers 40, 50 include respective optical reference elements 48, 58.

The respective interferometers of the system 1 may include one or more detectors 21, 31, 41, 51. The system 1 may include a reference detector 60. The system 1 may also include one or more beam splitters 62.

The present disclosure may refer to an optical path difference (OPD) of respective interferometers 20, 30, 40, 50. The OPD herein is the difference in length between the optical path towards respective reference elements 28, 38, 48, 58 and towards respective target reflectors 24, 34, 44, 54. In Fig. 2, the OPD of interferometers 20, 30, 40, 50 substantially corresponds to the lengths $L_{20}$, $L_{ref}$, $L_{40}$, and $L_{50}$ respectively.

An output of the respective detectors may be provided to respective inputs 70, 72, 74, 76 of an interferometer device 78. The interferometer device may be referred to as a phase measurement board or PMB. Where the first light beam and the second light beam of each interferometer is made to create an interference signal at the respective detectors, a task of the PMB may be to digitize the analog optical signals and to determine the phase of the interferometer signals. For instance, the phase of signals herein relates to the phases of the frequency signals of detectors 21, 31, 41, 51 relative to the phase of the frequency signal of a reference detector such as 60.

The interferometer device 78 may be coupled to a controller 80. The interferometer device 78 may be a measurement board. Said measurement board can, for instance, provide phase counts or frequency counts of digitized input signals.

In a practical embodiment, each light beam 4, 8 is a laser light beam. Each laser 2, 6 is provided with a unique carrier frequency. The carrier frequency is a frequency difference between a reference beam and a target beam. The measurement board 78 herein is adapted to track the phase of each carrier frequency. Said phase can be compared with the phase of the reference detector 60.

For instance, the centre frequency of the second (tunable) laser 6 may be calibrated by comparing the wavelength of second laser beam 8 against that of a known stabilized reference laser, such as the first laser beam 4. The latter may include a scaling comparison during a move of a target, such as one or more of objects 22 or 42 shown in Fig.

2. Once calibrated, the reference axis Lref can be used to measure changes in the wavelength the laser 6.

The respective detectors 21, 31, 41, 51 may detect or measure various optical effects. One such effect is a difference between the first light beam and the second light beam after they have passed through respective interferometers. Another effect includes fringe counts ('counts'). Herein, the number of fringe counts of a respective detector for a light beam having a given wavelength scales with the OPD of the respective interferometer.

Detector 60 may provide a reference to any respective measurement as described herein.

Any change in the number of fringe counts ($\Delta$cnt) of a respective detector scales with the length Li (or OPD) of the respective interferometer and a change in frequency $\Delta$f (or wavelength) of the input:

$$\Delta cnt_i \ = \frac{\Delta f}{c} * L_i \qquad (1)$$

Herein, c is the speed of light, and i represents an interferometer, such as one of interferometers 20, 30, 40, 50 as shown in Fig. 2.

In a practical embodiment, the setup shown in Figure 2 can be used to measure the length of the variable length of respective axes of interferometers 20, 40, 50 with respect to the reference length Lref of the wavelength tracker axis. The reference axis Lref of the wavelength tracker 30 can be determined using calibration techniques. With the OPD of the reference known, such as the interferometer axis Lref, observing changes in counts enables the OPD of another interferometer to be derived. This may be referred to as an estimated OPD ratio, OPDratio$_{est}$, which is given by:

$$OPDratio_{est} \ = \frac{OPD_{20}}{OPD_{30}} = \frac{L_{20}}{L_{30}} = \left( \frac{\Delta cnt_{20}(\Delta f)}{\Delta cnt_{30}(\Delta f)} \right) \qquad (2)$$

Then, the variable length $L_{20}$ of, for instance, the first interferometer 20 may be determined by modulating the frequency of the second light beam 8:

$$L_{20} \ = L_{ref} \left( \frac{\Delta cnt_{2,20}}{\Delta cnt_{2,30}} \right) \qquad (3)$$

Herein, $\Delta$cnt$_2$ represents tuning counts of respective detectors, counting fringe counts relating to the modulated light provided by the tunable light source 6. Herein, the counts relate to the first interferometer 20 and to the wavelength tracker (the second interferometer 30) respectively. In the example of Fig. 2, the third interferometer 30 is setup as a wavelength tracker WLT.

During the measurement, the variable axis $L_{20}$ may be kept constant, i.e. the target 22 does not move during the measurement. The movable target is kept at a constant position, for instance, when aiming to solve formula (4) below.

The setup may include a stabilized first light source 2 and a tunable second light source 6. Herein, respective detectors of respective interferometers may also detect fringe counts $\Delta$cnt$_1$ relating to the first light beam of the first light source. Thus, using formula (2) above, but using fringe counts $\Delta$cnt1 relating to a constant frequency laser 2 (instead of $\Delta$cnt2 relating to the tunable laser 6) enables to measure change of the variable length $L_{20}$ with respect to the reference axis Lref.

As described herein above, zeroing may be used to deal with fringe count errors. Zeroing may be based on a common path multiwavelength interferometer having a static reference axis $L_{ref}$ and another interferometer axis (such as $L_{20}$, $L_{40}$ or $L_{50}$) that can be a static axis or a moving axis.

A concept of zeroing based on multi wavelength tuning (MWT) may include minimizing the residual of a goal function. For instance, referring to formula (2), and taking into account frequency change $\Delta$f(t) as a function of time t, a fit residual res(t) may be described as:

$$res(\Delta f(t)) \ = \Delta cnt_{20}(\Delta f) - OPDratio_{est} * \Delta cnt_{30}(\Delta f) \qquad (4)$$

Herein, the OPDratio$_{est}$ may be determined using one of the first laser 2, having a fixed frequency, or the second tunable laser 6 with the output kept at a constant frequency.

A goal function for MWT zeroing may include:

$$res(\Delta f(t)) \ = \frac{cnt_{1,20}(\Delta f(t))}{cnt_{1,30}(\Delta f(t))} - \frac{cnt_{2,20}(\Delta f(t))}{cnt_{2,30}(\Delta f(t))} \qquad (5)$$

When using formula (5), motion of a movable target (such as objects 22 and 42 in Fig. 2) is allowed. Technically, for the purpose of zeroing, the movable object 22 may typically be kept static. However, for creating a frequency dependent noise fingerprint, the object 22 may be allowed to move to average out ghost rays from the movable axis interferometer, such as interferometer 20. This way, it is possible to distinguish between ghost rays in the movable axis interferometer 20, 40, 50 and ghost rays in the fixed axis interferometer 30. The fixed length interferometer is preferably as stable as possible. The reference axis Lref is the axis of which the method of the present disclosure aims to take a ghost ray noise fingerprint.

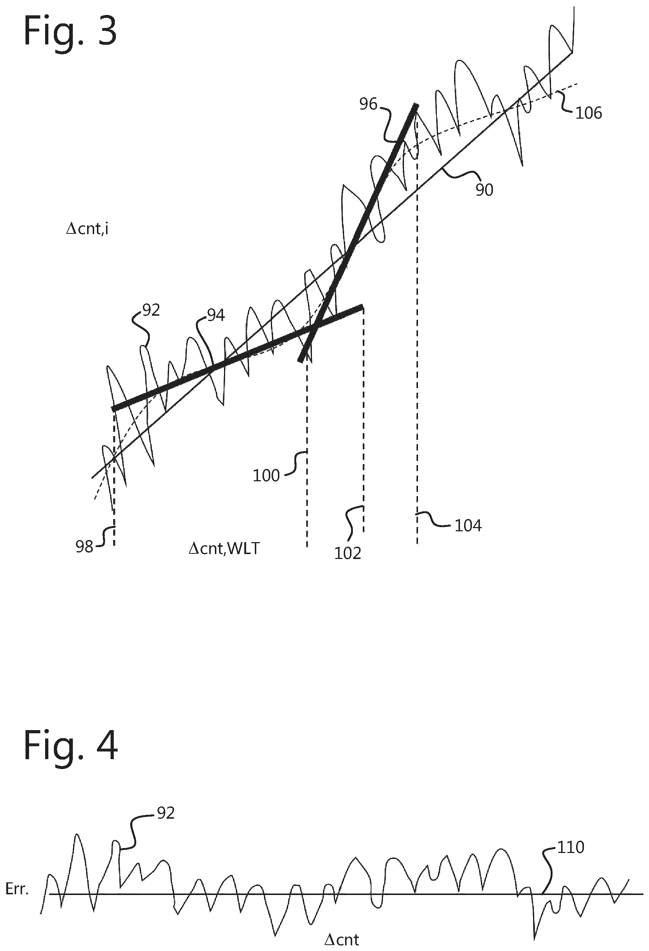

However, due to manufacturing tolerances or otherwise imperfect optics (for instance caused by achromatic behaviour of the optics), small laser frequency dependent inconsistencies may occur in the fit residual. See Figure 3.

Conventionally, a system may try to solve the equation (5) for a trace where at least one laser is a wavelength tuning laser by estimating offsets to minimize the residual:

$$res(\Delta f(t)) \quad = \frac{cnt_{1,20}(\Delta f(t)) + offset1}{cnt_{1,30}(\Delta f(t)) + offset2} - \frac{cnt_{2,20}(\Delta f(t)) + offset3}{cnt_{2,30}(\Delta f(t)) + offest4} \qquad (6)$$

Formulas (5) and (6) use the "absolute counts", not the delta counts. The absolute values, and potentially the offsets 1, 2, 3, 4, are basically obtained using a non-linear solver that minimizes the residual res($\Delta f(t)$). The minimized level of the residual can be used as a the frequency dependent noise fingerprint in accordance with the method of the present disclosure.

When using the non-linear solver without assuming knowledge about one or more of the offsets 1 to 4, the respective offsets can still be solved unambiguously by allowing some amount of motion of the target object on at least one of the interferometer axes.

Generally referring to Figure 3, in an ideal situation, the output of formula (2) above is a straight line 90. Herein, tuning counts of a variable length interferometer, such as the first interferometer 20, are represented on the vertical axis. Tuning counts of a reference, such as the third interferometer 30, are represented on the horizontal axis. The measured value, for instance the variable length $L_{20}$, is comparable to the slope of the line 90. The wavelength tracker counts $\Delta cnt,WLT$ on the horizontal axis substantially scale linearly with the (laser) frequency of the input light beam. See Formula (1) above. The interferometer counts represented on the vertical axis $\Delta cnt,i$ substantially correspond to phase at the detector of the respective interferometer.

However, as referenced above, the reflections in respective interferometers typically include ghost ray reflections. The latter can be observed as deviations 92 from the line 90. The deviations may, more generally, be referred to as (optical) noise.

As a result, a fit may deviate from the line 90. See lines 94, 96 respectively. As exemplified in Fig. 3, deviation of the fit residual may differ per frequency band, as indicated by section indicators 98, 100, 102, 104. The latter generally correspond to respective frequencies of the second light input 8, as provided by the tunable laser 6. Figure 3 also exemplifies an underlying modulation or harmonic 106 of the noise 92. As the measured value, such as the variable length $L_{20}$, is comparable to the slope of the line, due to the deviation of the fitted lines 94, 96, also the measured value deviated from the accurate value.

With reference to Figure 4, a fit residual of the exemplary measurement of Fig. 3 would result in a flat line 110. See formula (4) above. Figure 4 shows the error 92 as inconsistencies in the output. In the absence of inconsistencies in the optical reflections, the residual would return a value of zero for all frequencies. However, in practice there will virtually always be inconsistencies, or errors 92. The errors are typically dominated by ghost reflections.

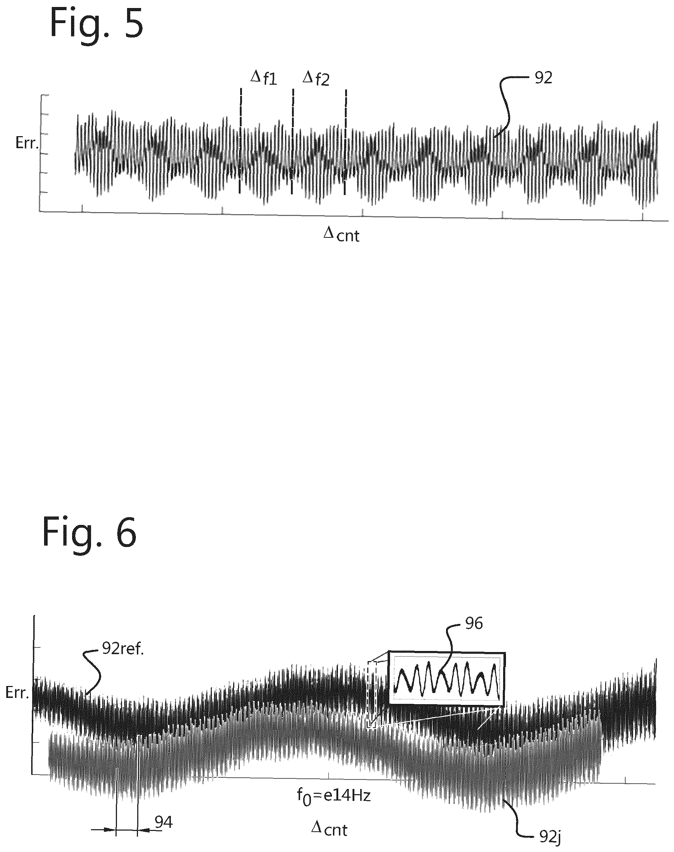

The inventors have found that, similarly to a spectral absorption cell, each interferometer axis with ghost reflections has a unique frequency dependent response. See for instance Figure 5. The diagram of Figure 5 exemplifies the residual function over a wider range of counts. Said range of counts corresponds to a frequency range of the light input.

During the frequency sweep of the tunable laser 6, each target object is kept in a fixed position. As a result, each interferometer has a fixed length during the sweep. Said length may be referred to as the OPD. The fixed length means that the wavelengths will fit in the respective OPD according to a laser frequency dependent pattern.

As exemplified in Figure 5, the error 92 also shows a pattern. Herein, first frequency range $\Delta f1$ and second frequency range $\Delta f2$, for instance, may cover a certain frequency range (for instance, about 10 GHz). In a practical embodiment, the tuning range of the laser may be on the order of 200 GHz. The latter may represent a full frequency sweep in Figure 5, from left to right.

True periodicity of the frequency dependent response is preferably avoided, as this would complicate pattern matching of a new noise fingerprint to the reference fingerprint. The pattern will become more unique if more harmonics from different ghost rays participate in the overall noise fingerprint. In fact, perfect periodicity of the error pattern (as exemplified in Figures 5 and 6) is actually an undesired property. The latter would indicate that there are an insufficient number of ghost ray reflections to create a truly unique fingerprint.

According to the present disclosure, the frequency dependent response is used to find the frequency of a tunable light source, such as a laser, by comparing to a reference measurement. The reference measurement, or reference state, can be conducted at an earlier moment. For instance, upon start of operation of the interferometer system.

The interferometer preferably includes at least one interferometer having a stable axis, which is used as a reference. In the example of Figure 2, this would be the wavelength tracker, i.e. the third interferometer 30 having stable reference axis Lref.

In a practical embodiment, the method of the disclosure focuses on the ghost ray noise fingerprint of the ultra-stable WLT axis. Herein, it may be beneficial if the other interferometer axes are provided with (slight) movement of the respective movable objects 22, 42. Thus, ghost ray content related to the adjustable length axes is averaged out while the ghost ray content originating from the ultra-stable WLT axis dominates the end result.

In an embodiment, the method of the disclosure includes signal processing, wherein both signals from the wavelength tracker and from one or more movable axes are included. The processing subsequently mathematically isolates harmonics that are consistent in amplitude in both the reference fingerprint and the new fingerprint. This way, harmonics that are included only in the reference fingerprint or only in the new fingerprint can be blocked. Herein, such harmonics do not originate from the WLT axis.

Referring to formula (1) above, the fit residual, as exemplified in Figure 5, comprises harmonics that correlate to the optical path length difference of interfering coherent laser beams:

$$OPD_i = c * \frac{\Delta cnt}{\Delta f} \qquad (7)$$

Generally referring to Figure 6, a method of the present disclosure includes a step wherein the above is used to create a reference fit residual 92ref. Herein, the OPD of a particular interferometer is fixed, and the frequency of the light input is swept from a first frequency f1 to a second frequency f2. As the OPD (Lref) of the third interferometer is fixed, typically, said measurement may include at least the fixed axis interferometer. During the reference measurement, the frequency of the light input is known. To this end, the reference measurement may include equipment, such as a stable reference laser or an optical measuring cell.

When a second measurement is done, with the target interferometer having the same OPD, then the resulting fit residual can be used to match the frequency of the light input, provided by the tunable laser 6, to the frequency of the tunable laser 6 during the first or reference measurement. Figure 6 exemplifies fit residual 92j (see formula 4 above) resulting from the jth measurement or frequency sweep.

Phase matching of the identified ghost reflections and/or correlation matching of the fit residual 92j of the jth measurement relative to the fit residual of the reference measurement 92ref can be used to match the frequency of the jth measurement to the frequency of the reference measurement 92ref.

In other words, matching the fit residual of the new, jth measurement, to the reference fit residual may indicate that the jth fit residual 92j has an offset 94 with respect to the reference. By changing the frequency of the light input to correct said offset 94, drift of the frequency of the tunable light source can be corrected as well.

Matching the jth fit residual to the reference fit residual may include various matching techniques.

For instance, for a particular measurement, the error or inconsistencies may be determined as a function of $count_{2,WLT}$. Herein, the OPD ratio may be included as determined using respective interferometer counts based on the first laser 2 having a fixed frequency output, such as frequency f1. Using a state of the art stabilized laser and an ultra-stable cavity for the wavelength tracker 30, this allows to determine the OPD ratio with an error not exceeding a single count. The OPD ratio herein is represented by:

$$OPDratio = \frac{cnt_{1,20}(f1)}{cnt_{1,30}(f1)} = \frac{cnt_{2,20}(f2)}{cnt_{2,30}(f2)} \qquad (8)$$

The counts describing the OPD ratio are "absolute counts". Compare this to the estimated OPD ratio, see formula (2). Basically, the counts may be frequency dependent, but the count ratio is equal to the OPD ratio and is therefore independent of the laser frequency. The result looks like the graph exemplified in Figure 4. In formula form this is represented by:

$$res = \Delta cnt_{2,20}(\Delta f) - OPDratio * \Delta cnt_{2,30}(\Delta f)$$

$$= \Delta cnt_{2,20}(\Delta f) - \frac{cnt_{1,20}(f1)}{cnt_{1,30}(f1)} * \Delta cnt_{2,30}(\Delta f) \qquad (9)$$

The method may perform fast Fourier transform (FFT) of the fit residual *res* derived using formula 9. Herein, harmonics in the signal may be determined. Phase and amplitude may be determined from said harmonics.

In an embodiment, the method of the disclosure equalizes the Fourier power spectra. Said equalizing of power spectrum may include the reference measurement as well as the later measurement. The equalizing of the power spectrum may relate to one or more frequency ranges of the fit residual. The latter is not a requirement but an optional improvement. By making the signals more equal in frequency content, the correlation search is only performed on the harmonics that are common. As referenced, this may relate to the entire fit residual, of to one or more frequency ranges of the fit residual. This approach improves the correlation search when trying to match the patterns of the first and second frequency range.

The results of the fast Fourier transform can be matched using, for instance, a ray trace model. The latter may assist to identify the root cause of ghost reflections.

In an embodiment, the method may zoom in on one or more sub-sets 96 of the fit residual. Said sub-set may cover a time range, frequency range or OPD range. The OPD range of a sub-set may be down to, for instance, a resolution on the order of picometers or below.

Phase matching may subsequently be used to match the new measurement to the reference measurement. In order to perform phase matching, the Fourier spectra of both the reference fingerprint and the new fingerprint may be made equal, such that only the smallest amplitude of each harmonic is used in the analysis. Thus, the impact of harmonics that are not common in both fingerprints (and are hence not the result of a ghost ray originating from the ultra-stable WLT axis) is reduced in the process of correlation matching. In a practical embodiment, correlation between matched and unmatched fit residuals can be smaller than 1 interferometer count. For instance, alignment reproduction can be down to the order of 0.005 counts.

In an embodiment, the method may include phase capturing the fringe counts for two or more interferometers, one thereof having a stable reference axis Lref, using the stabilized first light source 2. The noise fingerprint of multiple interferometer axes may be used in combination with the same wavelength tracker. By averaging the inconsistency, noise fingerprints relating to ghost ray reflections of each variable length interferometer is suppressed by averaging, while the common contribution of the WLT axis will be emphasized.

In an embodiment, the method may include phase capturing the fringe counts for two or more interferometers, one thereof having a stable reference axis Lref, using the tunable second light source 6. Herein, the noise fingerprint of the fit residual can be expressed as a function of the absolute wavelength tracker count $cnt_{2,30}$. Also in this embodiment, the noise fingerprint of multiple interferometer axes can be used in combination with the same wavelength tracker. By averaging the inconsistency, noise fingerprints relating to ghost ray reflections of each variable length interferometer can be suppressed by averaging while the common contribution of the WLT axis will be emphasized.

Correlation matching may be used to match the fingerprint of the fit residual of the $j^{th}$ measurement with the fit residual of the reference measurement.

In a practical embodiment, the signal that is used for correlation matching may be constructed as a linear combination of multiple signals that may originate from different interferometers that are fed by the same laser source.

Herein, in a practical embodiment, the OPD of variable length interferometer axes may be varied within a limited range, for example on the order of 1 mm. The slight motion of the target objects allows to reduce the sensitivity of non-static cavities by means of averaging.

The signals may be filtered prior to correlation matching to exclusively contain frequencies that are known to be static over time.

The method of the disclosure allows a frequency calibration of a tunable laser relative to a previous reference state without the need for additional hardware (such as a reference laser or iodine cell). The method obviates object stage moves for centre frequency reproduction measurements. A stage move may still be desired as a one-time absolute frequency calibration relative to a reference frequency, for instance for initial calibration or setup of the system.

According to the method of the disclosure, the initially undesirable ghost reflections are now used advantageously to determine the frequency of the tunable laser.

In an embodiment, the signals of multiple interferometers (typically having different cavity lengths) may be used to improve the robustness and ambiguity of the fitting algorithm. Herein, the frequency response of the two or more variable length interferometers may be averaged. As a result, the ghost reflection response of the wavelength tracker becomes more dominant in the overall error response. The latter, in turn, enables to match the frequency response to the frequency response of the wavelength tracker in particular, which will improve the accuracy of the matching algorithm.

The method and system of the disclosure enable to determine the centre frequency with a good reproducibility relative to a previous reference state.

As described above, an interferometer axis with ghost reflections typically has a unique frequency dependent response. According to the present disclosure, this unique frequency dependent response is used to calibrate the frequency of a tunable laser by comparing to a reference state. The reference state has been determined by an earlier measurement.

For instance, to capture a reference, the fingerprint of the ghost reflections of one or more axes of respective interferometers have been linked to the frequency of the tunable laser. Said frequency of the laser may have been determined, for instance, by other means or by calibration.

In time, the fit residual of the tunable laser will typically drift. Herein, the phase of the laser is shifted. The present disclosure matches the frequency response of ghost reflections in a second (later) measurement relative to the reference (earlier) measurement, to correct the drift.

The calibration can be applied to a multi-wavelength interferometer system with at least one measurement axis and at least one reference axis. The reference axis is typically a wavelength tracker. The reference axis may comprise an ultra-stable optical cavity. Ultra-stable herein may mean that the cavity is made of a material having (very) low thermal expansion and/or has low mechanical vibration. Materials may include, but are not limited to, crystalline materials such as sapphire or other ultra-low thermal expansion glass. An ultra-stable optical reference cavity (ORC) is commercially available, and is for instance marketed by Menlo Systems GmbH [DE].

Generally, two axes are measured simultaneously during a frequency sweep of the tunable laser. A unique, frequency-dependent "noise fingerprint" (also known as "inconsistency data" or "ghost ray analysis") of ghost frequency noise of the interferometer is obtained. By realigning the noise profile relative to the noise profile of the earlier reference measurement, a potential shift of phase of the tunable laser can be corrected.

Due to phase capture of the wavelength tracker axis Lref for both the stabilized laser and the tunable laser, each interferometer can be calibrated according to a two degree-of-freedom linear equation. Importantly, the method as disclosed herein allows for zeroing without requiring any additional hardware.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below. For instance, features of various embodiments as described above may be combined.

**Claims**

1. A method of calibrating a tunable light source in an interferometer system, the method comprising the steps of:

   - simultaneously performing a frequency sweep with the tunable light source across at least one measurement axis and a reference axis of the interferometer system to obtain a frequency response;
   - obtaining a fit residual of the frequency response of the tunable light source;
   - obtaining a noise fingerprint of the fit residual;
   - correlating the noise fingerprint to a reference noise fingerprint; and
   - calibrating the tunable light source based on the correlation between the noise fingerprint and the reference noise fingerprint.

2. The method of claim 1, wherein the step of obtaining a fit residual of the frequency response comprises obtaining a first fit for at least a first frequency range and a second fit for another, second frequency range.

3. The method of claim 1 or 2, wherein the step of obtaining a noise fingerprint comprises:

   performing a Fourier transform (FFT) of the fit residual; and
   equalizing the Fourier power spectrum.

4. The method of one of the previous claims, wherein the step of simultaneously performing a frequency sweep with the tunable light source includes performing a frequency sweep across multiple measurement axes and the reference axis of the interferometer system to obtain a frequency response.

5. The method of claim 4, wherein the step of obtaining the fit residual includes averaging the fit residual relating to the multiple measurement axes.

6. The method of one of the previous claims, wherein the step of calibrating the tunable light source comprises correcting a frequency of the tunable light source.

7. The method of one of claims 1 to 6, wherein the interferometer system has frequency dependent measurement errors.

8. Interferometer system, comprising at least a tunable light source, the system comprising:
   a controller adapted for calibrating the tunable light source, by:

   - simultaneously performing a frequency sweep with the tunable light source across at least one measurement axis and a reference axis of the interferometer system to obtain a frequency response;
   - obtaining a fit residual of the frequency response of the tunable light source;
   - obtaining a noise fingerprint of the fit residual;
   - correlating the noise fingerprint to a reference noise fingerprint; and
   - calibrating the tunable light source based on the correlation between the noise fingerprint and the reference noise fingerprint.

9. The system of claim 8, the controller further being adapted to obtain a first fit for at least a first frequency range and a second fit for another, second frequency range.

10. The system of one of claim 8 or 9, comprising a first light source for providing a stabilized first light output.

11. The system of one of claims 8 to 10,

    comprising multiple measurement axes,
    the controller being adapted to perform a frequency sweep across the multiple measurement axes and the reference axis of the interferometer system to obtain a frequency response, and to obtain the fit residual including averaging the fit residual relating to the multiple measurement axes.

12. Exposure apparatus, comprising at least one interferometer system according to one of claims 8 to 11.

13. A projection system for an optical lithography system, comprising at least one interferometer system according to one of claims 8 to 11.

# Fig. 1

Fig. 2

# Fig. 3

# Fig. 4

# Fig. 5

# Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2024002595 A1
- US 20230168077 A1
- US 20220048119 A